# EUROPEAN PATENT APPLICATION

(11) **EP 4 459 479 A1**
(43) Date of publication of application: **06.11.2024**
(21) Application number: 22922905.9
(22) Date of filing: 29.01.2022
(51) Int. Cl.: G06F 16/29, G06F 30/20

(54) **WORKFLOW CREATION METHOD AND APPARATUS, PLATFORM AND COMPUTER READABLE MEDIUM**

(71) Applicant: Siemens Aktiengesellschaft, 80333 München (DE)
(72) Inventor: ZHOU, Zhenhua, Shanghai 200120 (CN); WANG, Ting, Suzhou, Jiangsu 215332 (CN); ZHU, Xiaoxun, Beijing 100102 (CN)
(74) Representative: Isarpatent
(86) International application number: PCT/CN2022/075082
(87) International publication number: WO 2023/142075

(57) **Abstract**

The embodiments relate to the field of industrial technology, in particular to a workflow creation method and apparatus, a platform and a computer readable medium. Storing preset behavior tree nodes in a node library, the behavior tree nodes comprising main control nodes and function block nodes, the main control nodes being used for controlling the running state of a workflow, the main control nodes comprising a start node, an end node and a loop node, and each function block node being used for realizing operations of one resource in a working unit; displaying the node library on a graphical user interface; receiving a behavior tree construction and instantiation configuration operation implemented by a user on the graphical user interface on the basis of the node library, one behavior tree being used for representing one workflow, and the workflow being used for defining an operation to be executed by one working unit; and, in response to the construction of the behavior tree, generating a behavior tree instance corresponding to the workflow.

## Description

### TECHNICAL FIELD

Embodiments of the present application mainly relate to the field of industrial technologies, and in particular to a workflow creation method, apparatus and platform, and a computer-readable medium.

### BACKGROUND

A workflow may be simply defined as a description of a series of operation processes. The workflow is widely used in fields such as an automated system, artificial intelligence and robotics. For example, a workflow of a product sorting line in an automated system may be simply described as starting, taking photos, classifying, and moving products to target positions. A model deployment workflow in the field of artificial intelligence may be described as data collection, data annotation, model training, and model deployment.

However, currently, these workflows only have text descriptions. If a user wants to execute such workflows, the user needs to follow the text descriptions and may use multiple engineering tools. However, these tools are almost unrelated to each other and provide completely different user operation behaviors, which is not only a challenge to the user, but also greatly increases the cost, reduces the efficiency and limits flexibility due to a long development cycle. For example, in the field of artificial intelligence, a user needs to perform data collection by using a tool, perform data annotation manually or by using other tools, write Python scripts for model training, and perform deployment by using a deployment tool.

Therefore, those skilled in the art are still working on finding other workflow solutions.

### SUMMARY

Embodiments of the present application provide a workflow creation method, apparatus and platform, and a computer-readable medium, used for creating workflows quickly and conveniently.

According to a first aspect, a workflow creation method is provided, including: storing preset behavior tree nodes in a node library, the behavior tree nodes including main control nodes and function block nodes, the main control nodes being used for controlling a running state of a workflow, the main control nodes including a start node, an end node and a loop node, and each function block node being used for implementing operations of a resource in a workcell; displaying the node library on a graphical user interface; receiving construction of a behavior tree and an instantiation configuration operation performed by a user on the graphical user interface based on the node library, a behavior tree being used for representing a workflow, the workflow being used for defining operations to be executed by a workcell, and the construction of the behavior tree based on the node library including connecting the start node, the function block nodes, and the end node sequentially, or, connecting the start node, the function block nodes, and the loop node sequentially; and generating a behavior tree instance corresponding to a workflow in response to the construction of the behavior tree.

According to a second aspect, a workflow creation apparatus is provided, including components for executing the steps in the method provided in the first aspect.

According to a third aspect, a workflow creation platform is provided, including: at least one memory, configured to store computer-readable code; and at least one processor, configured to call the computer-readable code to execute the steps in the method provided in the first aspect.

According to a fourth aspect, a computer-readable medium is provided. The computer-readable medium stores computer-readable instructions, and the computer-readable instructions, when executed by a processor, cause the processor to execute the steps in the method provided in the first aspect.

According to a fifth aspect, a computer program product is provided. The computer program product is tangibly stored on a computer-readable medium and includes computer-readable instructions, and the computer-readable instructions, when executed, cause at least one processor to execute the steps in the method provided in the first aspect.

### BRIEF DESCRIPTION OF THE DRAWINGS

The following accompanying drawings are only intended to give schematic illustrations and explanations of the present application, but are not intended to limit the scope of the present application, where
FIG. 1 is a flowchart of a workflow creation method according to an embodiment of the present application;
FIG. 2 is a schematic diagram 1 of a behavior tree instance created according to an embodiment of the present application;
FIG. 3 is a schematic diagram 2 of a behavior tree instance created according to an embodiment of the present application;
FIG. 4 is an application scenario of an OT domain low code development platform 40 according to an embodiment of the present application in the field of industrial automation;
FIG. 5 is a schematic diagram of a workflow creation apparatus according to an embodiment of the present application, and
FIG. 6 is a schematic diagram of a workflow creation platform according to an embodiment of the present application.

### Descriptions of reference numerals:

| | | | | | |
|---|---|---|---|---|---|
| 100: | Workflow creation method | 101-104: | Method steps | | |
| 30: | Runtime of main controller of workcell | | | 31: | Knowledge middle platform |
| 32: | IT domain code development tool | 33: | Microservice | 40: | OT domain low code development platform |
| 41: | OT domain code development tool | 50: | Workflow apparatuscreation | 51: | Presetting module |
| 52: | Graphical interface module | 53: | Editing and processing module | | |
| 600: | Information processing platform | 601: | Memory | 602: | Processor |

### DETAILED DESCRIPTION

The subject matter described herein will now be discussed with reference to exemplary implementations. It should be understood that, discussion of the implementations is merely intended to make a person skilled in the art better understand and implement the subject matter described herein, and is not intended to limit the protection scope as defined in the claims, the applicability, or examples. Changes may be made to the functions and arrangements of the discussed elements without departing from the protection scope of the content of the embodiments of the present application. Various processes or components may be omitted, replaced, or added in each example according to requirements. For example, the described method may be executed according to a sequence different from the sequence described herein, and the steps may be added, omitted, or combined. In addition, features described in some examples may also be combined in other examples.

As used in this specification, the term "include" and variants thereof represent open terms, and mean "include but is not limited to". The term "based on" represents "at least partially based on". The terms "one embodiment" and "an embodiment" represent "at least one embodiment". The term "another embodiment" represents "at least one other embodiment". The terms "first", "second", and the like may represent different objects or the same object. Other definitions may be included explicitly or implicitly in the following. Unless otherwise clearly specified, the definition of one term is consistent in the entire specification.

The following describes the embodiments of this application with reference to the accompanying drawings.

OT devices may include, but are not limited to: Internet of things (IoT) devices, programmable logic controllers (PLCs), robotics, manual processes, and industrial personal computers (IPCs).

The applicable fields of the embodiments of the present application include, but are not limited to: industrial automation, logistics, laboratory, maritime, smart grids, electric vehicle infrastructure, electric vehicles, building automation, smart cities, water treatment, garbage recycling, and smart farm.

IT devices may include, but are not limited to: manufacturing operation management (MOM) systems, manufacturing execution systems (MES), enterprise resource planning (ERP) systems, enterprise service bus (ERB), and product lifecycle management (PLM) systems.

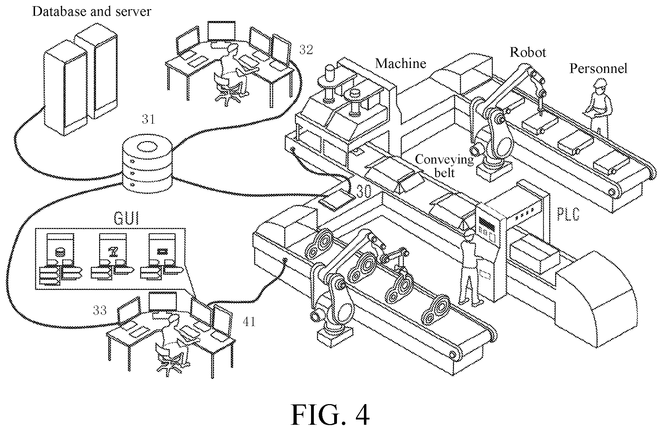

Low Code is essentially computer software that may be deployed on industrial control computers (IPCs) or single board computers (SBCs), corresponding to the computer next to the operator in the bottom left corner of FIG. 4 (the implementation is not limited to this and may be expanded to processor computers, processors, and the like), which may also be expanded to processors, computers, and the like. Low Code provides a graphical user interface for a user to perform OT domain and/or IT domain low code development.

A workcell may be a combination of systems or devices that can implement a relatively complete and independent control process and operation. In the embodiments of the present application, workflow creation is based on workcells as base units, which is more in line with the characteristics of industrial control, may improve the integration level of development, and may reduce the complexity of development. For example, in the field of industrial technologies, a workcell may be defined based on actual industrial scenarios, for example: a process may be defined corresponding to a workcell, or a work station in a process may be defined as a workcell, or a work position in a work station may be defined as a workcell. The process flows of different workcells are different.

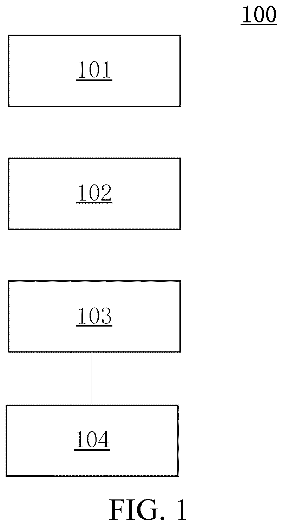

FIG. 1 is a flowchart of a workflow creation method according to an embodiment of the present application. As shown in FIG. 1, the workflow creation method includes:
Step 101: Preset behavior tree nodes are stored in a node library.

In the embodiments of the present application, the behavior tree nodes include main control nodes and function block nodes, and the main control nodes are used for controlling the running state of a workflow. The main control nodes include a start node, an end node and a loop node. Each function block node is used for implementing operations of a resource in a workcell.

Step 102: The node library is displayed on a graphical user interface.

Step 103: Construction of a behavior tree and an instantiation configuration operation performed by a user on the graphical user interface based on the node library are received.

In the embodiments of the present application, a behavior tree is used for representing a workflow, and the workflow is used for defining operations to be executed by a workcell, for example, representing a distributed process in a workcell. The construction of the behavior tree based on the node library includes: connecting the start node, the function block nodes, and the end node sequentially; or, connecting the start node, the function block nodes, and the loop node sequentially. Optionally, the sequential connection may be performed manually by a user. Optionally, by receiving semantic descriptions of a natural language inputted in a graphical user interface by a user, or based on semantic descriptions in a standard operating procedure (SOP), the relevant semantic descriptions may be parsed based on a rule engine to obtain the association relationships between various function block nodes. The relevant nodes are connected sequentially according to the progress of a workflow based on the association relationships between the function block nodes.

Generally, instantiation refers to a process of concretizing an abstract concept class into a physical object of the class. The instantiation configuration operation may include inputting parameters to be executed by a function block into the function block.

Step 104: A behavior tree instance corresponding to a workflow is generated in response to the construction of the behavior tree.

Specifically, an instance of a main control node is generated. The function block node is instantiated into operations to be executed by the corresponding resource based on the user's instantiation configuration operation.

In the embodiments of the present application, after a behavior tree instance corresponding to a workflow is generated, the behavior tree instance is parsed, and the workflow corresponding to the behavior tree instance is deployed to the runtime of a main controller of the corresponding workcell, so that the resources in the workcell connected to the main controller execute operations according to the workflow.

In the embodiments of the present application, the operations that can be executed by various classes of corresponding resources are encapsulated into corresponding function block nodes, the function block nodes are stored in a node library, and the main control nodes and the function block nodes are connected sequentially, thereby generating the behavior tree instance representing the operation process of a workflow. Due to the reusability of nodes, decoupling of a specific service and an engineering platform is implemented. Moreover, organizing nodes in the form of a behavior tree may generate intuitive workflow operation processes from development to implementation, thereby reducing the complexity of workflow construction and implementing quick and convenient workflow creation.

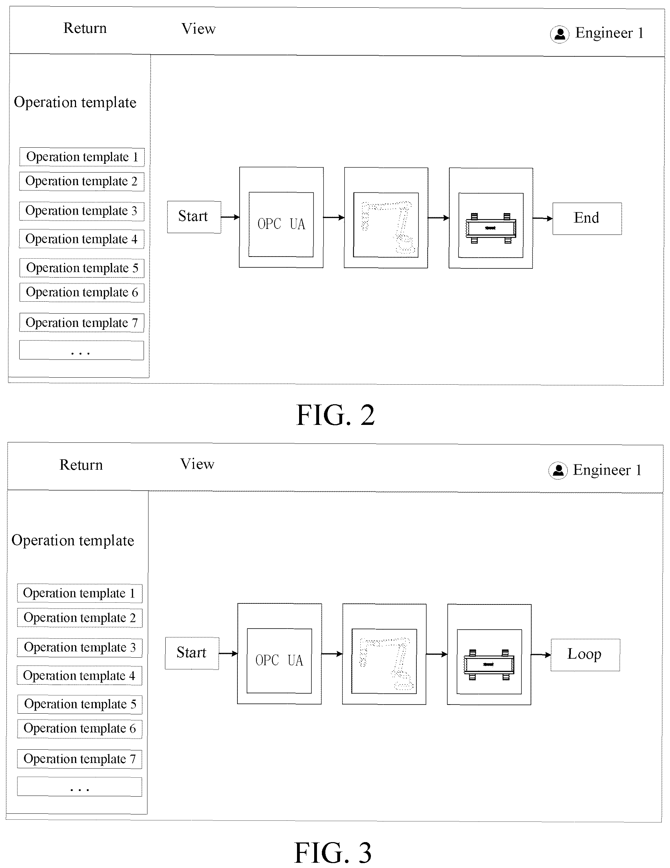

FIG. 2 is a schematic diagram 1 of a behavior tree instance created according to an embodiment of the present application. As shown in FIG. 2, after the start node, the function block nodes, and the end node are connected sequentially, resources corresponding to the function block nodes are initialized by scanning the function block nodes between the start node and the end node through the start node. After the resources in the workcell are powered on, initialization operations need to be performed to ensure normal running of related resources. The start node is an entrance to the entire process, and optionally, the start node may be displayed by default on the graphical user interface. By initializing the resources corresponding to all the function block nodes between the start node and the end node through the start node, the current situation where a user can only implement the initialization operations of related resources one by one through programming may be avoided. Therefore, the embodiments of the present application greatly reduce programming operations.

Resources corresponding to the function block nodes are reset by scanning the function block nodes between the start node and the end node through the end node. Before the resources in the workcell are powered off, the resources corresponding to all the function block nodes are reset through the end node, for example, controlling a robot to move to the default position, to ensure the safety of the workcell in management and running.

Optionally, the start node/end node may traverse all the function block nodes connected between the start node and the end node through a directed graph with loops.

FIG. 3 is a schematic diagram 2 of a behavior tree instance created according to an embodiment of the present application. As shown in FIG. 3, after the start node, the function block nodes, and the loop node are connected sequentially, execution of the start node is skipped through the loop node. The workflow of the first function block node connected to the start node is initiated, so that the behavior tree instance executes the workflow in a loop.

In some embodiments, the function block nodes may be stored in a node library in the form of operation templates. As shown in the operation templates on the left side of FIG. 2, each function block node corresponds to one operation template, and the operation template predefines the operations that can be executed by a class of resources. The operations include actions, methods, or skills.

In some embodiments, when generating a behavior tree instance corresponding to a workflow, labels unique in the behavior tree instance are added to all behavior tree nodes selected by a user. The labels include numbers, letters, or Chinese characters. The labels on the behavior tree nodes may help a user quickly locate the position of a target node in the behavior tree instance. In addition, if the operation process corresponding to the behavior tree instance generated on the graphical user interface needs to be exported as the content in an SOP, then the labels are the chapter numbers in that SOP.

An application scenario of an OT domain low code development platform 40 provided in an embodiment of the present application in the field of industrial automation is shown in FIG. 4. An OT domain code development tool 41 generates a behavior tree instance corresponding to an OT domain workflow under the operation of a user, and the OT domain workflow defines the operation to be executed by a production line as a workcell shown on the right side in FIG. 4. A corresponding workflow is generated based on the behavior tree instance and deployed to the runtime 30, so that the runtime 30 controls completion of the production line operation of the workcell. Furthermore, based on the behavior tree instance, a corresponding microservice may be generated by a microservice generator 33 and registered in a knowledge middle platform 31, such that an IT domain code development tool 32 may call the corresponding microservice through the knowledge middle platform 31. A user can edit the OT domain behavior tree instance by dragging and editing the nodes including the function block nodes as shown in the GUI at the lower left corner in FIG. 4. For example, first, required data (e.g., workpiece processing parameters) is obtained from a database and a server through the knowledge middle platform 31 to control running of the entire workcell. Here, the workcell is a production line, and the production line includes machines, conveying belts, mechanical arms, personnel, PLCs, AGBs, and the like, i.e., various resources in one production line.

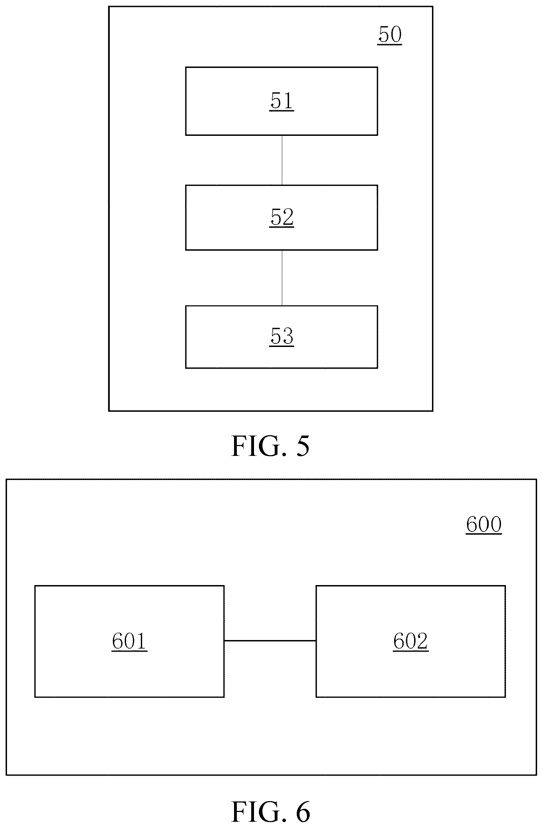

FIG. 5 is a schematic diagram of a workflow creation apparatus 50 according to an embodiment of the present application. As shown in FIG. 5, the workflow creation apparatus 50 includes:
a presetting module 51, a graphical interface module 52, and an editing and processing module 53. The presetting module 51 is configured to store preset behavior tree nodes in a node library. The behavior tree nodes include main control nodes and function block nodes, and the main control nodes are used for controlling the running state of a workflow. The main control nodes include a start node, an end node and a loop node. Each function block node is used for implementing operations of a resource in a workcell.

The graphical interface module 52 is configured to provide a graphical user interface for a user to perform construction of a behavior tree and an instantiation configuration operation based on the node library. A behavior tree is used for representing a workflow. The workflow is used for defining operations to be executed by a workcell. The construction of the behavior tree based on the node library includes: connecting the start node, the function block nodes, and the end node sequentially; or, connecting the start node, the function block nodes, and the loop node sequentially. The graphical interface module 52 is further configured to display the node library on the graphical user interface.

The editing and processing module 53 is configured to generate a behavior tree instance corresponding to a workflow in response to the construction of the behavior tree.

The embodiments of the present application further provide a device control platform 600. FIG. 6 is a schematic diagram of a device control platform 600 according to an embodiment of the present application. As shown in FIG. 6, the device control platform 600 includes a processor 602 and a memory 601. The memory 601 stores instructions, and the instructions, when executed by the processor 602, implement the aforementioned method 100.

The at least one processor 602 may include a microprocessor, an application specific integrated circuit (ASIC), a digital signal processor (DSP), a central processing unit (CPU), a graphics processing unit (GPU), a state machine, or the like. Examples of a computer-readable medium include, but are not limited to, a floppy disk, a CD-ROM, a magnetic disk, a memory chip, an ROM, an RAM, an ASIC, a configured processor, an all-optical medium, all magnetic tapes or other magnetic media, or any other medium from which a computer processor may read instructions. In addition, various other forms of computer-readable media may send instructions to a computer or carry the instructions, including routers, private or public networks, or other wired and wireless transmission devices or channels. The instructions may include codes of any computer programming language, including C, C++, C language, Visual Basic, java and Java Script.

Furthermore, the embodiments of the present application provide a computer-readable medium. The computer-readable medium stores computer-readable instructions, and the computer-readable instructions, when executed by a processor, cause the processor to execute the aforementioned OT domain low code development method. Examples of the computer-readable medium include a floppy disk, a hard disk, a magneto-optical disk, an optical disk (e.g., a CD-ROM, a CD-R, a CD-RW, a DVD-ROM, a DVD-RAM, a DVD-RW, and a DVD+RW), a magnetic tape, a non-volatile storage card, and an ROM. Optionally, the computer-readable instructions may be downloaded from a server computer or cloud through a communication network.

It should be noted that not all steps and modules in the above processes and system structure drawings are necessary, and some steps or modules may be omitted according to actual requirements. The execution sequence of the steps is not fixed and may be adjusted according to requirements. The system structure described in the above embodiments may be a physical structure or a logical structure. That is, some modules may be implemented by the same physical entity, or some modules may be implemented by a plurality of physical entities, or may be implemented by some components in a plurality of independent devices together.

## Claims

1. A workflow creation method, comprising:
- storing (101) preset behavior tree nodes in a node library, the behavior tree nodes comprising main control nodes and function block nodes, the main control nodes being used for controlling a running state of a workflow, the main control nodes comprising a start node, an end node and a loop node, and each function block node being used for implementing operations of a resource in a workcell;
- displaying (102) the node library on a graphical user interface;
- receiving (103) construction of a behavior tree and an instantiation configuration operation performed by a user on the graphical user interface based on the node library, a behavior tree being used for representing a workflow, the workflow being used for defining operations to be executed by a workcell, and the construction of the behavior tree based on the node library comprising: connecting the start node, the function block nodes, and the end node sequentially, or, connecting the start node, the function block nodes, and the loop node sequentially; and
- generating (104) a behavior tree instance corresponding to a workflow in response to the construction of the behavior tree.

2. The method according to claim 1, wherein the generating (104) a behavior tree instance corresponding to a workflow comprises:
- generating an instance of a main control node; and
- instantiating the function block node into operations to be executed by the corresponding resource based on the user's instantiation configuration operation.

3. The method according to claim 1 further comprising:
- after generating (104) a behavior tree instance corresponding to a workflow, parsing the behavior tree instance, and deploying the workflow corresponding to the behavior tree instance to the runtime of a main controller of the corresponding workcell, so that the resources in the workcell connected to the main controller execute operations according to the workflow.

4. The method according to claim 1 further comprising: storing the function block nodes in the node library in the form of operation templates, each function block node corresponding to one operation template, the operation template predefining the operations that can be executed by a class of resources, and the operations comprising actions, methods, or skills.

5. The method according to claim 1, wherein after connecting the start node, the function block nodes, and the end node sequentially, the method further comprising:
- scanning the function block nodes between the start node and the end node through the start node;
- initializing resources corresponding to the function block nodes;
- scanning the function block nodes between the start node and the end node through the end node; and
- resetting resources corresponding to the function block nodes.

6. The method according to claim 1, wherein after connecting the start node, the function block nodes, and the loop node sequentially, the method further comprising:
- skipping execution of the start node through the loop node; and
- initiating the workflow of the first function block node connected to the start node, so that the behavior tree instance executes the workflow in a loop.

7. The method according to claim 1 further comprising:
- when generating (104) a behavior tree instance corresponding to a workflow, adding labels unique in the behavior tree instance to all behavior tree nodes selected by a user, the labels comprising numbers, letters, or Chinese characters.

8. A workflow creation apparatus, comprising:
- a presetting module (51), configured to:
- store preset behavior tree nodes in a node library, the behavior tree nodes comprising main control nodes and function block nodes, the main control nodes being used for controlling a running state of a workflow, the main control nodes comprising a start node, an end node and a loop node, and each function block node being used for implementing operations of a resource in a workcell;
- a graphical interface module (52), configured to:
- provide a graphical user interface for a user to perform construction of a behavior tree and an instantiation configuration operation based on the node library, a behavior tree being used for representing a workflow, the workflow being used for defining operations to be executed by a workcell, and the construction of the behavior tree based on the node library comprising: connecting the start node, the function block nodes, and the end node sequentially, or, connecting the start node, the function block nodes, and the loop node sequentially; and
- display the node library on the graphical user interface; and
- an editing and processing module (53), configured to:
- generate a behavior tree instance corresponding to a workflow in response to the construction of the behavior tree.

9. A workflow creation platform, comprising:
at least one memory (601), configured to store computer-readable code; and
at least one processor (602), configured to call the computer-readable code to execute the steps of the method according to any one of claims 1 to 7.

10. A computer-readable medium, wherein the computer-readable medium stores computer-readable instructions, the computer-readable instructions, when executed by a processor, causing the processor to execute the steps of the method according to any one of claims 1 to 7.

11. A computer program product, wherein the computer program product is tangibly stored on a computer-readable medium and comprises computer-readable instructions, the computer-readable instructions, when executed, causing at least one processor to execute the method according to any one of claims 1 to 7.
